Europäisches Patentamt

European Patent Office

Office européen des brevets

(19)

(11) **EP 1 393 439 B1**

(12) **EUROPÄISCHE PATENTSCHRIFT**

(45) Veröffentlichungstag und Bekanntmachung des Hinweises auf die Patenterteilung:
**22.11.2006 Patentblatt 2006/47**

(21) Anmeldenummer: **02750626.0**

(22) Anmeldetag: **28.05.2002**

(51) Int Cl.:
*H03H 9/17* (2006.01)    *G01N 27/00* (2006.01)

(86) Internationale Anmeldenummer:
**PCT/AT2002/000160**

(87) Internationale Veröffentlichungsnummer:
**WO 2002/097984 (05.12.2002 Gazette 2002/49)**

(54) **Messanordnung, beinhaltend ein PIEZOELEKTRISCHES RESONATORELEMENT DER KRISTALLOGRAPHISCHEN PUNKTGRUPPE 32**

Measurement device, including a PIEZOELECTRIC RESONATOR ELEMENT OF CRYSTALLOGRAPHIC POINT GROUP 32

Dispositif de mesure, comprenant un ELEMENT RESONATEUR PIEZO-ELECTRIQUE DU GROUPE PONCTUEL CRISTALLOGRAPHIQUE 32

(84) Benannte Vertragsstaaten:
**AT BE CH CY DE DK ES FI FR GB GR IE IT LI LU MC NL PT SE TR**

(30) Priorität: **31.05.2001 AT 8482001**

(43) Veröffentlichungstag der Anmeldung:
**03.03.2004 Patentblatt 2004/10**

(73) Patentinhaber: **Akubio Limited Cambridge CB4 0GJ (GB)**

(72) Erfinder:
• **THANNER, Herbert A-8020 Graz (AT)**
• **KREMPL, Peter A-8047 Kainbach (AT)**

(74) Vertreter: **Specht, Peter et al Loesenbeck - Stracke - Specht - Dantz Am Zwinger 2 33602 Bielefeld (DE)**

(56) Entgegenhaltungen:
• **KREMPL P ET AL: "Gallium phosphate, GaPO4: A new piezoelectric crystal material for high-temperature sensorics" SENSORS AND ACTUATORS A, ELSEVIER SEQUOIA S.A., LAUSANNE, CH, Bd. 61, Nr. 1-3, 1. Juni 1997 (1997-06-01), Seiten 361-363, XP004092250 ISSN: 0924-4247**

• **F. EICHELBAUM ET AL.: "Oszillatoren für Quartz-Crystal-Microbalance-Sensoren in Flüssigkeiten" TECHNISCHES MESSEN TM., Bd. 65, Dezember 1998 (1998-12), Seiten 434-444, XP008007806 R.OLDENBOURG VERLAG. MUNCHEN., DE ISSN: 0171-8096 in der Anmeldung erwähnt**

• **POSTNIKOV I I: "EFFECT OF TEMPERATURE ON FREQUENCY CHARACTERISTICS OF CONTOURED-QUARTZ THICKNESS-SHEAR-TYPE VIBRATORS" ACOUSTICAL PHYSICS, AMERICAN INSTITUTE OF PHYSICS. NEW YORK, US, Bd. 40, Nr. 4, 1. Juli 1994 (1994-07-01), Seiten 586-592, XP000464917 ISSN: 1063-7710**

• **NAKAZAWA M. ET AL: 'Reliable quadric for frequency-turnover temperature vs. orientation of rotated Y-cut quartz plate resonator oscillating in the third overtone C-mode in the vicinity of AT-cut' 1995 JAPAN IEMT SYMPOSIUM. PROCEEDINGS OF 1995 JAPAN INTERNATIONAL ELECTRONIC MANUFACTURING TECHNOLOGY SYMPOSIUM CAT. NO.95CH35994 IEEE NEW YORK, NY, USA Seiten 170 - 174**

• **ANDLE J.C. ET AL: 'Acoustic plate mode properties of rotated Y-cut quartz' ULTRASONICS SYMPOSIUM, 1996. PROCEEDINGS., 1996 IEEE, SAN ANTONIO, TX USA Nr. 2, 03 November 1996, Seiten 971 - 976**

- **BECHMANN R.: 'Frequency-Temperature-Angle Characteristics of AT- and BT-Type Quartz Oscillators in an Extended Temperature Range' PROCEEDINGS OF THE INSTITUTE OF RADIO ENGINEERS Bd. 48, Nr. 8, August 1960, Seite 1494, XP009066241**

**Beschreibung**

Die Erfindung betrifft eine Messanordnung, beinhaltend ein Piezoelektrisches Resonatorelement der kristallographischen Punktgruppe 32, welches als Dickenscherschwinger in Kontakt mit einem Trägermedium betreibbar ist sowie eine Messanordnung zur Bestimmung zumindest eines chemischen, biochemischen oder physikalischen Parameters in einem Trägermedium, welches Trägermedium mit einem eine elektrische Kontaktierung und ggf. zumindest eine sensitive Schicht aufweisenden piezoelektrischen Resonatorelement der kristallographischen Punktgruppe 32 zumindest einseitig in Kontakt bringbar ist, wobei zumindest eine Resonanzeigenschaft, vorzugsweise die Resonanzfrequenz, des als Dickenscherschwingers betriebenen Resonatorelementes ein Maß für den zu bestimmenden chemischen, biochemischen oder physikalischen Parameter darstellt.

Derartige Resonatorelemente werden beispielsweise in Mikrowaagen eingesetzt, welche den Effekt ausnützen, dass die Resonanzeigenschaften eines piezoelektrischen Resonators, meist eines Dickenscherschwingers, durch die Massenbeladung an der Resonatoroberfläche, der Viskosität oder aber auch der elektrischen Leitfähigkeit des angrenzenden Mediums, verändert werden. Vielfach werden solche Mikrowaagen zur in-situ Messung der Schichtdicke über die Massenbeladung benutzt. Bei dieser Anwendung werden die Mikrowaagen in Vakuum betrieben. In den letzten Jahren wurde diese Technik jedoch auch auf die Bestimmung der Konzentration bestimmter Komponenten in Flüssigkeiten bzw. in Gasen eingesetzt, wobei zumindest eine Oberfläche des Resonators meist mit einer selektiv bindenden Schicht versehen ist, welche im wesentlichen nur die zu messende Substanz an der Oberfläche des Resonators bindet und so die schwingende Masse erhöht.

Da die Resonanzeigenschaften eines piezoelektrischen Resonators neben der schwingenden Masse auch von Kapazitäten, welche seriell oder parallel zum Resonator wirken abhängen, ist es auch möglich elektrische Eigenschaften wie z.B. die Leitfähigkeit oder die Dielektrizitätskonstante bzw. deren Änderungen von Flüssigkeiten oder Gasen zu messen.

Nachteilig bei all diesen Anwendungen ist jedoch, dass sowohl Temperaturänderung direkt im Resonator als auch in dem zu messenden Medium einen zum Teil großen Einfluss auf die Resonanzeigenschaften, insbesondere auf die Resonanzfrequenz des Resonators haben und dadurch entweder sehr aufwendige und teure Temperiereinrichtungen vorgesehen werden müssen um den Einfluss von Temperaturschwankungen berücksichtigen zu können oder aber eine reduzierte Nachweisempfindlichkeit des Sensors in Kauf genommen werden muss. So ist z.B. aus dem Artikel von F. Eichelbaum, R. Borngräber, R. Lucklum, P. Hauptmann und S. Rösler "Oszillatoren für Quartz-Crystal-Microbalance-Sensoren in Flüssigkeiten", Technisches Messen 65 (1998) bekannt, dass die Temperaturabhängigkeit der Resonanzfrequenz bzw. der Oszillatorfrequenz der vorwiegend verwendeten Quarz AT-Schnitt Resonatoren - welche an Luft, insbesondere bei Raumtemperatur sehr gering ist - in einseitigem Kontakt mit Wasser einen stark angestiegenen Temperaturgang von ca. 35 Hz/°C bei einer Grundfrequenz von 10 MHz aufweist. In einer von der Grundfrequenz unabhängigen Angabe sind das 3,5 ppm/°C.

In der US 5,487,981 A wird beispielsweise der Einfluss von Temperaturänderungen in einer Flüssigkeit auf die Resonanzfrequenz eines Quarz AT-Dickenscherschwingers mit einem Widerstandsthermometer gemessen und mit Hilfe eines programmierbaren Controllers die entsprechende Offset-Frequenz berechnet und elektronisch kompensiert. Eine derartige Vorgangsweise ist allerdings relativ aufwendig.

Der Temperaturgang der Resonanzfrequenz eines piezoelektrischen Resonator kann beispielsweise nach folgender Gleichung beschrieben werden:

$$\frac{f(T) - f(T_0)}{f(T_0)} = a(T - T_0) + b(T - T_0)^2 + b(T - T_0)^3$$

mit

$f(T)$...Resonanzfrequenz bei der Temperatur $T$
$f(T_0)$...Resonanzfrequenz bei der Bezugstemperatur $T_0$
$a, b, c$...linear, quadratischer und kubischer Temperaturkoeffizient.

Die Bezugstemperatur $T_0$ kann dabei willkürlich gewählt werden. In dieser Patentschrift wird nur der lineare Temperaturkoeffizient $a$ zur Beschreibung des Temperaturganges der Resonanzfrequenz $f(T)$ verwendet, welcher beispielsweise durch einen "Linear-Fit" in einem vorbestimmten Temperaturbereich, beispielsweise zwischen 10 °C und 40 °C ermittelt werden kann. Der quadratische und kubische Temperaturkoeffizient wird vernachlässigt.

Aufgabe der Erfindung ist es, eine Messanordnung mit einen Resonator zur Bestimmung eines chemischen, biochemischen oder physikalischen Parameters in einem Trägermedium vorzuschlagen, bei welchem die oben angeführten Nachteile vermieden werden. Die Nachweisempfindlichkeit der Messung soll auch bei auftretenden Temperaturschwankungen im Resonator bzw. dem zu messenden Medium - unter Einsparung aufwendiger Korrekturmaßnahmen - aufrecht erhalten bzw. verbessert werden.

Die Erfindung löst diese Aufgabe dadurch, dass das Resonatorelement ein von temperaturkompensierten Kristallschnitten in Luft oder Vakuum abweichender, im Wesentlichen um den Winkel Φ um die kristallografische x-Achse gedrehter, einfach rotierter Y - Schnitt ist, welcher ohne Kontakt mit dem Trägermedium in einem vorbestimmten Temperaturbereich, vorzugsweise zwischen 10 °C und 40 °C, einen negativen Temperaturgang der Resonanzfrequenz $f(T)$ aufweist, wobei bei Kontakt mit dem Trägermedium der Betrag des linearen Temperaturkoeffizienten a der Resonanzfrequenz im Messbereich kleiner 1 ppm/°C, vorzugsweise kleiner 0,5 ppm/°C ist.

Es hat sich überraschend gezeigt, dass ein piezoelektrischer Resonator, welcher an Luft im Temperaturbereich zwischen 20 °C und 35 °C einen negativen linearen Temperaturkoeffizienten a der Resonanzfrequenz $f(T)$ aufweist - dessen Betrag zwischen 0,5 ppm/°C und 3,5 ppm/°C liegt - in einseitigem Kontakt mit destilliertem Wasser, einen nahezu temperaturunabhängigen Frequenzgang in diesem Temperaturbereich aufweist.

Die Wechselwirkung zwischen der schwingenden Oberfläche des Resonators und dem angrenzenden Medium ist maßgeblich von der angeregten Schwingungsform abhängig. Bei piezoelektrischen Resonatoren sind im wesentlichen longitudinale und transversale Moden anregbar.

Im Falle einer Longitudinalmode ist die Auslenkungsrichtung der Kristalloberfläche im wesentlichen normal auf die Resonatoroberfläche gerichtet. In diesem Fall zeigen die Resonatoren insbesondere in Kontakt mit einer Flüssigkeit eine starke Dämpfung der resonanten Schwingung wodurch auch der Messbereich bzw. die Auflösung solcher Sensoren stark eingeschränkt wird.

Ein wesentlich günstigeres Schwingverhalten insbesondere in Kontakt mit flüssigen Medien weisen jedoch Resonatoren auf, bei welchen im wesentlichen transversale Schwingungsmoden angeregt werden. Die bekanntesten Vertreter dieser Klasse sind die sogenannten Dickenscherschwinger wie z.B. der Quarz AT oder BT Schnitt.

Der Temperaturgang der Resonanzfrequenz eines piezoelektrischen Resonators ist durch die Schnittrichtung des Resonatorplättchens bezüglich der kristallografischen Achsen gegeben.

Die Angabe der Vorzeichen der Schnittwinkel Φ bezüglich deren Drehrichtung um die kristallografischen Achsen erfolgen nach dem "IEEE Standard on Piezoelectricity; ANSI/IEEE Std. 176-1987.

Allerdings wird in der Quarzindustrie nach wie vor der Standard aus dem Jahre 1949 verwendet, wobei sich ein umgekehrtes Vorzeichen für den Schnittwinkel ergibt.

Der Unterschied soll in der nachstehenden Tabelle verdeutlicht werden:

| Standard | Quarz AT (Φ [°]) | Quarz BT (Φ [°]) |
|---|---|---|
| 1949 | +35°15'[*] | -48°50'[*] |
| 1987 | -35°15' | +48°50' |
| [*] J. Zelenka: Piezoelectric Resonators and their Applications, Elsevier (1986) | | |

Je nach Anwendung und verwendetem Material für das piezoelektrische Resonatorelement ist erfindungsgemäß vorgesehen, bei einem niedrigviskosem (kinematische Viskosität $\gamma < 15$ mm$^2$ s$^{-1}$ bei 25 °C), vorzugsweise wässrigen Trägermedium, welches in zumindest einseitigem Kontakt mit dem Resonator steht, folgende Schnittwinkel Φ gewählt werden:

im Falle von Quarz in den Bereichen:

-36,5 ° ±1,1 °, vorzugsweise -35,9 ° ±0,5°

+52,5 ° ±3,0°, vorzugsweise +51,4 ° ±1,3°

im Falle von Langasit im Bereich:

+6,3 ° ±3,0 °, vorzugsweise +5,3 ° ±2,0 ° und

im Falle von Galliumorthophosphat im Bereich:

-21,2 ° ±4,5°, vorzugsweise -18,5 ° ±1,7°.

Gemäß einer Ausführungsvariante, bei welcher der Resonator mit einem viskosem Trägermedium (kinematische Viskosität $\gamma$>15 mm² s⁻¹ bei 25 °C), beispielsweise Öl, in zumindest einseitigem Kontakt steht, sind folgende Schnittwinkel Φ vorgesehen:

im Falle von Quarz in den Bereichen:

-45,0 ° ±7,0 °, vorzugsweise -41,5 ° ±3,5 °

+60,0 ° ±8,0 °, vorzugsweise +60,0 ° ±6,0 °

im Falle von Langasit im Bereich:

+30,0 ° ±19,0 °, vorzugsweise +22,0 ° ±11,0 ° und

im Falle von Galliumorthophosphat im Bereich:

-35,0° ±10,0 °, vorzugsweise -40,0 ° ±5,0 °.

Die für den erfindungsgemäßen Resonator aufgezeigten Vorteile bleiben weitgehend erhalten, wenn bei der Herstellung des Resonators darauf geachtet wird, dass eine der Drehung um die x-Achse vorausgehende Drehung um die z-Achse klein gehalten wird, wobei Werte zwischen -10 ° und +10 °, vorzugsweise zwischen -5 ° und +5 ° zugelassen sind.

Die vorliegende Erfindung wird anhand von Abbildungen näher erläutert. Es zeigen

Fig. 1    ein erfindungsgemäßes piezoelektrisches Resonatorelement,

Fig. 2    eine Messanordnung mit einem erfindungsgemäßen piezoelektrischen Resonatorelement in einer Schnittdarstellung,

Fig. 3    eine schematische Darstellung der Messanordnung und

Fig. 4    den Temperaturgang der Resonanzfrequenz des Resonatorelementes nach Fig. 1 in Luft und in Wasser.

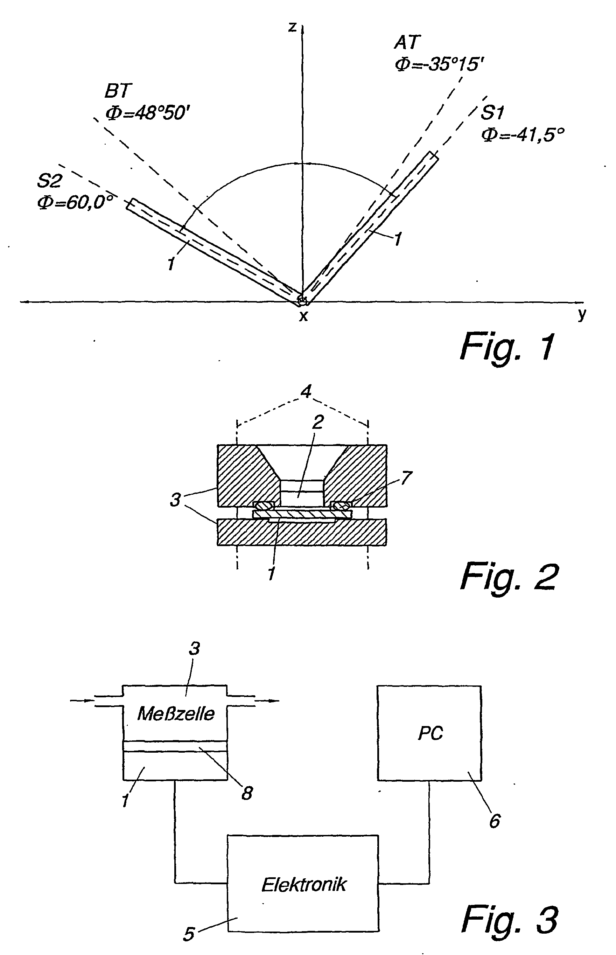

In Fig. 1 sind beispielsweise die Schnittwinkel Φ für zwei erfindungsgemäße Resonatorelemente 1 aus Quarz - die beiden einfach rotierten Y - Schnitt S1 und S2 - im Vergleich zu den in Luft oder Vakuum temperaturkompensierten AT- bzw. BT- Schnitten dargestellt, wobei die Schnitte S1 und S2 für viskose Trägermedien, beispielsweise Öl, optimiert sind.

Fig. 2 zeigt eine zweiteilige Flüssigkeitsmesszelle 3 deren Teile an zwei Stellen 4 mit Schrauben miteinander verbunden sind. Dazwischen befindet sich ein piezoelektrisches Resonatorelement 1 mit an den Deckflächen angebrachten Elektroden, welcher mit Hilfe eines elastischen Dichtringes 7 gegenüber der oberen Gehäusehälfte abgedichtet wird. Das zu untersuchende Trägermedium bzw. Flüssigkeit 2 steht dabei in direktem Kontakt mit der zu piezoelektrischen Schwingungen anregbaren Resonatoroberfläche. Das Resonatorelement 1 kann zum Schutz gegenüber aggressiven Trägermedien eine chemisch reaktionsarme Schutzschicht aufweisen.

Fig. 3 zeigt schematisch eine erfindungsgemäße Messanordnung. Das piezoelektrische Resonatorelement 1 welcher sich in der Flüssigkeitsmesszelle 3 befindet, ist dabei mit der Mess- und Auswerteelektronik 5,6 elektrisch verbunden. Die Resonatoroberfläche kann eine für zumindest einen Probenparameter sensitive Schicht 8 aufweisen.

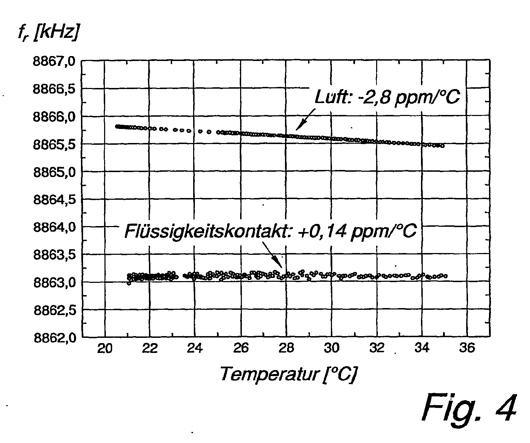

Fig. 4 zeigt die gemessenen Temperaturgänge der Resonanzfrequenzen eines Quarz Dickenscher-Resonators (Φ= -35,6°), welcher an beiden Seiten mit Goldelektroden versehen ist, an Luft und in einseitigem Kontakt mit destilliertem Wasser im Temperaturbereich zwischen 20 °C und 35 °C. Während der Temperaturgang der Resonanzfrequenz des in Luft schwingenden Resonators einen negativen linearen Temperaturkoeffizienten a mit einem Betrag von ca. 2,8 ppm/°C aufweist, ist der lineare Temperaturkoeffizient a der Resonanzfrequenz des Resonators mit einseitigem Flüssigkeitskontakt etwa 20 mal kleiner und beträgt ca. 0,14 ppm/°C.

**Patentansprüche**

1. Messanordnung zur Bestimmung zumindest eines chemischen, biochemischen oder physikalischen Parameters in einem flüssigen Trägermedium (2), wobei die Messanordnung ein piezoelektrisches Resonatorelement der kristallographischen Punktgruppe 32 aufweist, dessen Oberfläche eine sensitive Schicht (8) aufweist, wobei zumindest eine Resonanzfrequenz des als Dickenschwingers betriebenen Resonatorelements (1) ein Maß für den zu bestimmenden Parameter darstellt, **dadurch gekennzeichnet, daß** das Resonatorelement (1) ein von temperaturkompensierten Kristallschnitten in Luft oder Vakuum abweichender, im wesentlichen um einen Winkel Φ um die kristallografische x-Achse gedrehter, rotierter Y-Schnitt (S1, S2) ist, welcher ohne Kontakt mit dem Trägermedium in einem vorbestimmten Temperaturbereich zwischen 10 °C und 40 °C, einen negativen Temperaturgang der Resonanzfrequenz *f(T)* aufweist, wobei bei Kontakt mit dem Trägermedium der Betrag des linearen Temperaturkoeffizienten *a* der Resonanzfrequenz im Messbereich kleiner 1 ppm/°C ist.

2. Messanordnung nach Anspruch 1, **dadurch gekennzeichnet, dass** bei Kontakt mit dem Trägermedium der Betrag des linearen Temperaturkoeffizienten a der Resonanzfrequenz im Messbereich kleiner 0,5 ppm/°C ist.

3. Messanordnung nach Anspruch 1 oder 2, **dadurch gekennzeichnet, dass** sie zur Analyse einer Substanz in einem niedrigviskosem Trägermedium betreibbar ist, **dadurch gekennzeichnet, daß** der Schnittwinkel Φ:

   - im Fall eines Quarzresonatorelements in den Bereichen -36,5° ±1,0° und +52,5° ±3,0° liegt
   - im Falle eines Langasitelementes im Bereich +6,3° ±3,0° lieget, und
   - im Falle eines Galliumorthophosphatelements im Bereich:-21,2° ±4,5 liegt.

4. Messanordnung nach Anspruch 3, **dadurch gekennzeichnet, dass** sie zur Analyse einer Substanz mit einem niedrigviskosem Trägermedium betreibbar ist, wobei der Schnittwinkel Φ:

   - im Fall eines Quarzresonatorelements in den Bereichen -35,9° ±0,5° und +51,4° ±1,3° liegt,
   - im Falle eines Langasitresonatorelements im Bereich +5,3° ±2,0° liegt, und
   - im Falle eines Galliumorthophosphatresvnatorelements im Bereich: -18,5° ±1.7 liegt.

5. Messanordnung nach Anspruch 3 oder 4, **dadurch gekennzeichnet, daß** das Trägermedium mit niedriger Viskosität ein wässriges Trägermedium ist.

6. Messanordnung nach Anspruch 1, **dadurch gekennzeichnet, dass** sie zur Analyse einer Substanz in einem viskosen Trägermedium, beispielsweise Öl, betreibbar ist, wobei der Schnittwinkel Φ

   - im Fall eines Quarzresonatorelements in den Bereichen -45,0° ±7,0° und +60,0° ±8,0° liegt,
   - im Falle eines Langasitresonatorelements im Bereich +30,0° ± 19,0° liegt, und
   - im Falle eines Galliumorthophosphatresonatorelements im Bereich: -35,0° ±10.0 liegt.

7. Messanordnung nach Anspruch 6, **dadurch gekennzeichnet, dass** sie zur Analyse einer Substanz in einem viskosen Trägermedium, beispielsweise Öl, betreibbar ist, wobei der Schnittwinkel Φ

   - im Fall eines Quarzresonatorelements in den Bereichen -41,5° ±3,5° und +60,0° ±6,0° liegt,
   - im Falle eines Langasitresvnatvrelements im Bereich +22,0° ± 11,0° liegt, und
   - im Falle eines Galliumorthophosphatresonatorelements im Bereich: -40,0° ±5.0° liegt.

8. Messanordnung nach Anspruch 1, **dadurch gekennzeichnet, daß** der Drehung um die x-Achse eine Drehung um die z-Achse zwischen -10° und +10° vorausgeht.

9. Messanordnung nach Anspruch 1, **dadurch gekennzeichnet, daß** der Drehung um die x-Achse eine Drehung um die z-Achse zwischen -5° und +5° vorausgeht.

10. Verfahren zur Herstellung eines piezoelektrischen kristallographischen Resonatorelements für eine Messanordnung zur Bestimmung zumindest eines chemischen oder physikalischen Parameters einer Substanz in einem flüssigen Trägermedium oder der Interaktion der Substanz mit einer sensitiven Schicht des Elementes, mit folgenden Schritten:

    a) Bestimmen des Temperaturkoeffizienten der Resonanzfrequenz in Luft oder Vakuum eines gedrehten Y-Schnitts des Kristalls um die x-Achse um verschiedene Winkel, über einen vorbestimmten Temperaturbereich zwischen 10 °C und 40 °C,

b) Bestimmen, ob der Kristall einen negativen linearen Temperaturkoeffizienten über diesen Temperaturbereich in Luft oder Vakuum aufweist; welcher derart ist, dass der lineare Temperaturkoeffizient der Resonatorfrequenz des Kristalls in Kontakt mit dem flüssigen Trägermedium kleiner als 1ppm/°C beträgt.,

c) Auswählen des Kristalls unter Verwendung der Daten des Schritts a), wenn der Temperaturkoeffizienten in Luft oder Vakuum Bedingung des Schritts b) genügt, und

d) Beschichten wenigstens einer Oberfläche des Kristalls mit einer sensitiven Schicht.

**Claims**

1. Measurement device for the determination of at least one chemical, biochemical or physical parameter in a liquid carrier medium (2), the measurement device having a piezoelectric resonator element of crystallographic point group 32, whose surface has a sensitive coating (8) and at least one resonant frequency of the resonator element (1) operated as a thickness oscillator constituting a measure for the parameter to be determined, **characterized in that** the resonator element (1) is a rotated Y-section (S1, S2) diverging from temperature-compensated crystal sections in air or vacuum and rotated essentially by an angle Φ about the crystallographic x-axis and which, without contact with the carrier medium, in a predetermined temperature range between 10 and 40°C has a negative temperature variation of the resonant frequency f(T) and in contact with the carrier medium the value of the linear temperature coefficient a of the resonant frequency is in the measurement range below 1 ppm/°C.

2. Measurement device according to claim 1, **characterized in that** in contact with the carrier medium the value of the linear temperature coefficient a of the resonant frequency is in the measurement range lower than 0.5 ppm/°C.

3. Measurement device according to claim 1 or 2, **characterized in that** it is operable for the analysis of a substance in a low viscosity carrier medium, **characterized in that** the cutting angle Φ:

   - in the case of a quartz resonator element is in the ranges -36.5° ±1.0° and +52.5° ±3.0°,
   - in the case of a langasite element in the range +6.3° ±3.0° and
   - in the case of a gallium orthophosphate element in the range -21.2° +4.5°.

4. Measurement device according to claim 3, **characterized in that** it is operable for the analysis of a substance with a low viscosity carrier medium, in which the cutting angle Φ:

   - in the case of a quartz resonator element is in the ranges -35.9° ±0.5° and +51.4° ±1.3°,
   - in the case of a langasite resonator element in the range +5.3° ±2.0° and
   - in the case of a gallium orthophosphate resonator element in the range -18.5° ±1.7°.

5. Measurement device according to claim 3 or 4, **characterized in that** the low viscosity carrier medium is an aqueous carrier medium.

6. Measurement device according to claim 1, **characterized in that** it is operable for the analysis of a substance in a viscous carrier medium, e.g. oil, in which the cutting angles Φ:

   - in the case of a quartz resonator element is in the ranges -45.0° ±7.0° and +60.0° ±8.0°,
   - in the case of a langasite resonator element in the range +30.0° ±19.0° and
   - in the case of a gallium orthophosphate resonator element in the range -35.0° ±10.0°.

7. Measurement device according to claim 6, **characterized in that** it is operable for the analysis in a substance in a viscous carrier medium, e.g. oil, in which the cutting angles Φ:

   - in the case of a quartz resonator element is in the ranges -41.5° ±3.5° and +60.0° ±6.0°,
   - in the case of a langasite resonator element in the range +22.0° ±11.0° and
   - in the case of a gallium orthophosphate resonator element in the range -40.0° ±5.0°.

8. Measurement device according to claim 1, **characterized in that** a rotation about the z-axis of -10 to +10° precedes the rotation about the x-axis.

9. Measurement device according to claim 1, **characterized in that** a rotation about the z-axis between -5 and +5° precedes the rotation about the x-axis.

10. Method for the manufacture of a piezoelectric crystallographic resonator element for a measurement device for the determination of at least one chemical or physical parameter of a substance in a liquid carrier medium or the interaction of the substance with a sensitive coating of the element, involving the following steps:

   a) determination of the temperature coefficient of the resonant frequency in air or vacuum of a rotated Y-section of the crystal about the x-axis by different angles over a predetermined temperature range between 10°C and 40°C,
   b) determination as to whether the crystal has a negative linear temperature coefficient over this temperature range in air or vacuum and which is such that the linear temperature coefficient of the resonant frequency of the crystal in contact with the liquid carrier medium is lower than 1 ppm/°C,
   c) selection of the crystal using the data of step a), if the temperature coefficient in air or vacuum satisfies the condition of step b) and
   d) coating at least one surface of the crystal with a sensitive coating.

**Revendications**

1. Dispositif de mesure détermination d'au moins un paramètre chimique, biochimique ou physique dans un milieu porteur fluide (2), le dispositif de mesure présentant un élément à résonateur piézoélectrique du groupe ponctuel cristallographique 32 dont la surface présente une couche sensible (8), au moins une fréquence de résonance de l'élément de résonateur (1) utilisé comme oscillateur d'épaisseur représentant une mesure du paramètre à déterminer, **caractérisé en ce que** l'élément de résonateur (1) est une coupe Y (S1, S2) qui diffère des coupes cristallines compensées en température dans l'air ou dans le vide, tourné essentiellement d'un angle Φ autour de l'axe cristallographique X et qui, sans contact avec le milieu porteur, présente dans une plage de température prédéterminée de 10°C à 40°C une variation négative de la fréquence de résonance en fonction de la température $f(T)$, tandis qu'en contact avec le fluide porteur, la valeur du coefficient linéaire de température $\alpha$ de la fréquence de résonance dans la plage de mesure est inférieure à 1 ppm/°C.

2. Agencement de mesure selon la revendication 1, **caractérisé en ce qu'**en contact avec le fluide porteur, la valeur du coefficient linéaire de température $\alpha$ de la fréquence de résonance dans la plage de mesure est inférieure à 0,5 ppm/°C.

3. Agencement de mesure selon les revendications 1 ou 2, **caractérisé en ce qu'**il peut être utilisé pour l'analyse d'une substance dans un milieu porteur peu visqueux, **caractérisé en ce que** l'angle de coupe Φ :

   est compris dans les plages de -36,5° ± 1,0° et de +52,5° ± 3,0° dans le cas où l'élément résonateur est en quartz,
   est compris dans la plage de +6,3° ± 3,0° au cas où l'élément est en langasite et
   est compris dans la plage de -21,2° ± 4,5° au cas où l'élément est en orthophosphate de gallium.

4. Agencement de mesure selon la revendication 3, **caractérisé en ce qu'**il peut être utilisé pour analyser une substance avec un milieu fluide peu visqueux, et dans lequel l'angle de coupe Φ :

   est compris dans les plages de -35,9° ± 0,5° et de +51,4° ± 1,3° dans le cas où l'élément résonateur est en quartz,
   est compris dans la plage de +5,3° ± 2,0° au cas où l'élément est en langasite et
   est compris dans la plage de -18,5° ± 1,7° dans le cas d'un élément à l'orthophosphate de gallium.

5. Agencement de mesure selon les revendications 3 ou 4, **caractérisé en ce que** le milieu porteur à basse viscosité est un milieu porteur aqueux.

6. Agencement de mesure selon la revendication 1, **caractérisé en ce qu'**il peut être utilisé pour analyser une substance dans un milieu porteur visqueux, par exemple de l'huile, et dans lequel l'angle de coupe Φ:

   est compris dans les plages de -45,0° ± 7,0° et de +60,0° ± 8,0° dans le cas où l'élément résonateur est en quartz,
   est compris dans la plage de +30,0° ± 19,0° au cas où l'élément est en langasite et
   est compris dans la plage de -35,0° ± 10,0° dans le cas d'un élément à l'orthophosphate de gallium.

**7.** Agencement de mesure selon la revendication 6, **caractérisé en ce qu'**il peut être utilisé pour analyser une substance dans un milieu porteur visqueux, par exemple de l'huile, et dans lequel l'angle de coupe Φ :

est compris dans les plages de -41,5° ± 3,5° et de +60,0° ± 6,0° dans le cas où l'élément résonateur est en quartz, est compris est compris dans la plage de + 22,0° ± 11,0° au cas où l'élément est en langasite et dans la plage de - 40,0° ± 5,0° dans le cas d'un élément à l'orthophosphate de gallium.

**8.** Agencement de mesure selon la revendication 1, **caractérisé en ce que** la rotation autour de l'axe x précède une rotation autour de l'axe z comprise entre -10° et +10°.

**9.** Agencement de mesure selon la revendication 1, **caractérisé en ce que** la rotation autour de l'axe x précède une rotation autour de l'axe z comprise entre -5° et +5°.

**10.** Procédé de préparation d'un élément résonateur piézoélectrique cristallographique pour un agencement de mesure destiné à déterminer au moins un paramètre chimique ou physique d'une substance dans un milieu porteur liquide ou à déterminer l'interaction de la substance avec une couche sensible de l'élément, lequel procédé présente les étapes suivantes :

a) détermination du coefficient de température de la fréquence de résonance dans l'air ou dans le vide d'une coupe y du cristal tournée autour de l'axe x sur différents angles et dans une plage de température prédéterminée comprise entre 10°C et 40°C,
b) vérification si le cristal présente dans l'air ou dans le vide et dans cette plage de température un coefficient de température linéaire négatif tel que le coefficient linéaire de température de la fréquence de résonance du cristal en contact avec le milieu porteur liquide est inférieure à 1 ppm/°C,
c) si le coefficient de température dans l'air ou le vide satisfait la condition de l'étape b), sélection du cristal en recourant aux données de l'étape a) et
d) recouvrement d'au moins une surface du cristal par une couche sensible.

**Fig. 1**

**Fig. 2**

**Fig. 3**

Fig. 4